## Europäisches Patentamt

(19) **European Patent Office**   (11) Numéro de publication: **0 166 647**

**Office européen des brevets**   **B1**

(12) **FASCICULE DE BREVET EUROPÉEN**

(45) Date de publication du fascicule du brevet:
06.03.89

(51) Int. Cl.⁴: **H 01 L 21/84,** H 01 L 29/78

(21) Numéro de dépôt: **85401125.1**

(22) Date de dépôt: **07.06.85**

---

(54) **Procédé de fabrication d'au moins un transistor à effet de champ en couche mince, et transistor obtenu par ce procédé.**

---

(30) Priorité: **14.06.84 FR 8409310**

(43) Date de publication de la demande:
**02.01.86 Bulletin 86/1**

(45) Mention de la délivrance du brevet:
**06.03.89 Bulletin 89/10**

(84) Etats contractants désignés:
**DE GB NL**

(56) Documents cité:
**EP-A-0 090 661
EP-A-0 102 802
US-A-4 358 340**

**IEEE ELECTRON DEVICE LETTERS, vol.EDL-3, no. 7,
7 juillet 1982, pages 187-189, New York, US; T.
KODAMA et al.:"A self-alignment process for
amorphous silicon thin film transistors"
SID INTERNATIONAL SYMPOSIUM, DIGEST OF
TECHNICAL PAPERS, 1 mai 1983, pages 144,145;
Lewis Winner, Coral Gables, US; K. ASAMA et
al.:"A self-alignment processed a-Si TFT matrix
circuit for LCD panels"**

(73) Titulaire: **THOMSON- CSF, 173, Boulevard
Haussmann, F-75379 Paris Cédex 08 (FR)**

(72) Inventeur: **Szydlo, Nicolas, THOMSON- CSF SCPI
173, bld Haussmann, F-75379 Paris Cedex 08 (FR)**
Inventeur: **Boulitrop, François, THOMSON- CSF
SCPI 173, bld Haussmann, F-75379 Paris Cedex 08
(FR)**

(74) Mandataire: **Lepercque, Jean, THOMSON- CSF
SCPI 19, avenue de Messine, F-75008 Paris (FR)**

---

LIBER, STOCKHOLM 1989

## Description

La présente invention concerne un procédé de fabrication de transistors à effet de champ, en couche mince, du type à autoalignement des électrodes. Ce procédé s'applique au domaine de la microélectronique en grande surface et en particulier à la commande et à l'adressage d'un écran plat à cristal liquide ou d'un senseur d'images. Il peut également s'appliquer à la réalisation de dispositifs à commutation rapide pour intégration sur grandes surfaces.

Pour les dispositifs électroniques sur grandes surfaces, le silicium en couche mince est la technique la plus développée actuellement. Le silicium est alors utilisé sous forme amorphe ou polycristalline. La majorité des études réalisées actuellement concerne le transistor MISFET en couche mince (TFT). Pour les applications en grande surface, il est nécessaire que les temps de réponse des transistors de type TFT soient les plus brefs possible. Dans le cas du silicium amorphe dont on connaît la faible mobilité des porteurs, les fréquences de travail sont actuellement limitées à quelques centaines de kHz. De plus, avec ce matériau, les courants à saturation sont faibles si bien que l'application de ces transistors reste limitée à l'adressage point par point d'un écran à cristal liquide. Pour des applications telles que la commande périphérique d'un écran de visualisation ou un registre à décalage, des fréquences de travail plus élevées sont requises ainsi que des courants à saturation plus élevés. Pour parvenir à ces résultats, il est nécessaire de surmonter certaines contraintes technologiques. Les longueurs de canal doivent être les plus courtes possible afin de minimiser le temps de parcours et le piégeage des porteurs. Il est préférable, surtout dans le cas du silicium amorphe, de choisir de grandes largeurs de canal afin d'obtenir des courants à saturation élevés. Le semiconducteur en couche mince et l'isolant de grille doivent être déposés consécutivement et dans le même dispositif de dépôt afin de préserver une bonne qualité de l'interface semiconducteur-isolant. Il est nécessaire de disposer de bons contacts de source et de drain. Il est souvent indispensable, dans le cas des dispositifs en couche mince réalisés sur de grandes surfaces, d'utiliser une technologie d'autoalignement des électrodes.

Les transistors de type TFT développés actuellement ont une longueur de canal de l'ordre de 10 µm avec autoalignement ou non des électrodes de source et de drain par rapport à la grille. Des longueurs de canal plus petites ont été réalisées. On peut citer dans l'ordre décroissant: 8 µm pour une largeur de canal W de 100 µm (Y. OKURO et al, SID 82 Digest, p. 40), 7 µm pour W = 45 µm (M. YAMANO et al, Japan Display 83, p. 356), ces deux transistors étant destinés à l'adressage matriciel d'un écran à cristal liquide. On peut encore citer un transistor ayant 3 µm de lonqueur de canal et destiné à un senseur d'images (A.J. SNELL et al, Journal of Non-Cryst. Sol., 59 et 60, 1983, p. 1211). Dans ces trois cas, les transistors sont élaborés avec grille dessous par des procédés de photolithographie classiques.

Dans les procédés de fabrication classiques par photogravure, les largeurs des canaux dépendent de leurs longueurs. La plus grande largeur obtenue est de l'ordre de 1500 µm pour une longueur de 10 µm (K. SUZUKI et al, DID 83 Digest, p. 146).

On rencontre couramment des largeurs comprises entre 100 et 400 µm dans le cas du silicium amorphe. Au-delà apparaissent des difficultés technologiques liées à la procedure elle-même: résolution des masques et des machines d'alignement, superposition, définition des attaques, etc...

Afin de pallier ces inconvénients, l'invention propose un procédé de fabrication de façon collective de transistors de type TFT à grille submicronique et autoalignée avec la source et le drain. Typiquement, la longueur du canal sera comprise entre 0,5 et 1 µm. Un tel transistor, réalisé en silicium amorphe, permet une utilisation jusqu'à des fréquences de quelques dizaines de mégahertz. Si le transistor est réalisé en silicium polycristallin, la fréquence maximale d'utilisation peut être repoussée jusqu'à quelques centaines de mégahertz. De genre de transistors trouve son application dans une électronique plus rapide en grande surface.

L'invention a donc pour objet un procédé de fabrication conforme à celui de la revendication 1.

L'invention a aussi pour objet un procédé de fabrication conforme à celui de la revendication 15.

L'invention a encore pour objet un transistor conforme à celui de la revendication 30.

L'invention sera mieux comprise et d'autres avantages apparaîtront à la lecture de la description qui va suivre et d'après les figureŝ annexées, parmi lesquelles:

- les figures 1 à 11 illustrent les différentes étapes d'une première variante du procédé de fabrication selon l'invention,
- les figures 12 à 19 illustrent différentes étapes d'une seconde variante du procédé de fabrication selon l'invention.

Dans le cas d'un transistor à grille dessous, c'est-à-dire en contact avec le substrat, deux types de réalisation peuvent être envisagés suivant la précision requise pour l'autoalignement.

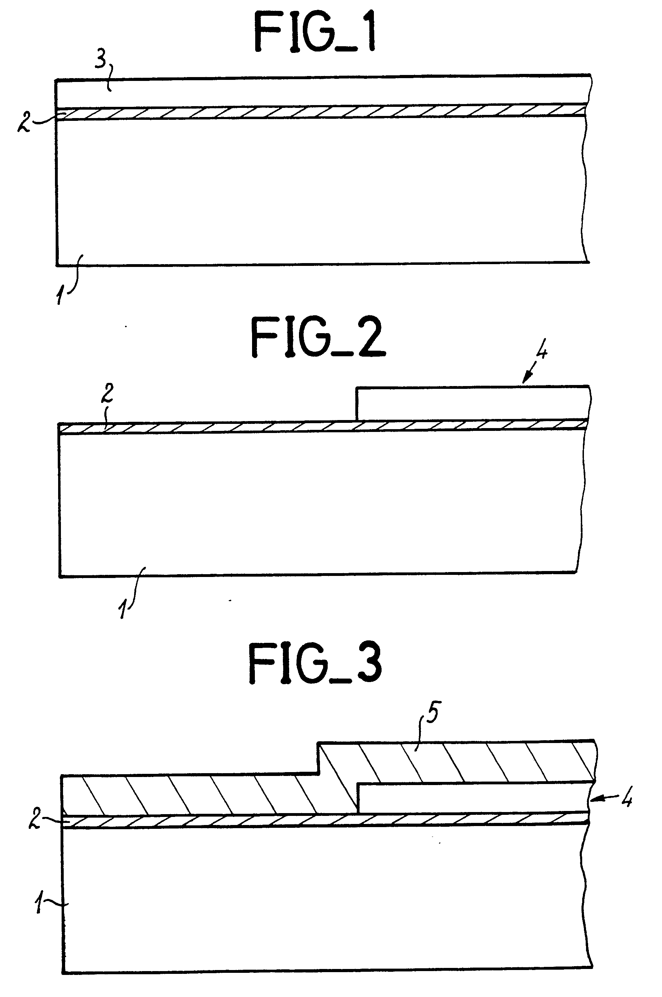

Les figures 1 à 11 vont concerner une première variante de réalisation. La figure 1 illustre la première étape du procédé. Sur un substrat 1 isolant et transparent, par exemple en verre, on dépose une couche métallique 2 destinée à former la future électrode de grille. Le métal déposé peut être de l'aluminium, un alliage nickel-chrome ou du chrome déposé par un moyen classique d'évaporation. L'épaisseur de la couche 2 peut être de l'ordre de 100 nm. Une couche 3 d'un premier matériau, qui peut être de l'oxyde de silicium SiO$_2$ d'une épaisseur d'environ 0,5 µm, est déposé sur la couche 2. Au cours de la deuxième étape du procédé, la couche 3 est gravée par des moyens photolithographiques classiques comme indiqué à la figure 2 de façon à délimiter une mésa 4. Comme on le constate sur cette figure, la gravure a été menée jusqu'à atteindre la couche métallique 2. La figure 2 ainsi que celles qui suivront sont des vues partielles. En effet, on ne représentera que la fabrication d'un seul transistor afin de ne pas surcharger les figures. Il va de soi qu'à partir d'une seule mésa, il est possible de fabriquer plusieurs transistors. La gravure de la mésa 4 constitue un premier niveau de masquage.

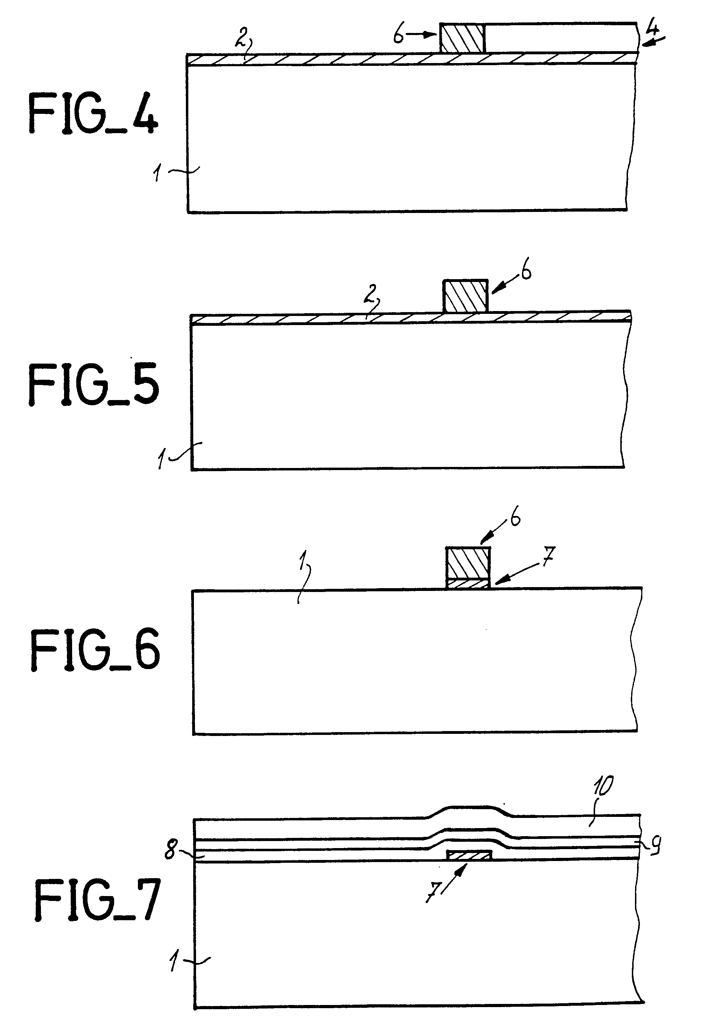

La troisième étape du procédé, illustrée par la figure 3, comprend le dépôt à une température compatible avec le substrat, par exemple par la méthode LPCVD ou par la méthode de décharge luminescente, d'une couche 5 d'un second matériau différent du matériau de la couche 3, qui peut être du silicium amorphe ou polycristallin si la couche 3 est en SiO$_2$. Ces méthodes donnent une épaisseur uniforme au dépôt quel que soit l'angle présenté par le substrat par rapport aux arrivées des gaz vecteurs. L'épaisseur de la couche 5 est fonction de la longueur de grille désirée, en pratique entre 0,5 et 1 µm. La couche 5 épouse le relief constitué par la couche 2 et la mésa 4. La quatrième étape du procédé est constituée par l'attaque directionnelle de la couche 5. Cette attaque est menée, comme illustré à la figure 6, jusqu'à ne laisser subsister de la couche 5 que le ressaut 6 sur le flanc de la mésa 4. L'attaque directionnelle peut être réalisée par attaque ionique réactive RIE (Reactive Ion Etching) à l'aide d'un plasma de tétrafluorure de carbone CF$_4$ seul ou assisté par de l'oxygène.

La cinquième étape est constituée par l'élimination de la mésa 4. Ceci est facilement réalisable grâce à la sélectivité des sauces d'attaque. Le dispositif obtenu à l'issue de la cinquième étape est représenté à la figure 5.

La sixième étape est constituée par l'attaque de la couche métallique 2 non protégée par le ressaut 6. De cette manière on délimite la longueur de la grille submicronique matérialisée par le ressaut métallique 7, comme indiqué à la figure 6. Le ressaut 6 est éliminé, lors de la septième étape du procédé, par attaque chimique. La figure grille du transistor sera donc entièrement métallique et présentera par conséquent une résistance électrique pratiquement nulle. La face du substrat 1 supportant le ressaut métallique 7 est alors recouverte, lors de la huitième étape, de dépôts successifs constitués par une couche d'isolant de grille 8, d'une couche d'un matériau semiconducteur 9 et éventuellement une couche d'un isolant de passivation 10. L'isolant de grille peut être de l'oxyde de silicium SiO$_2$ ou de l'oxynitrure de silicium SiON ou encore du nitrure de silicium Si$_3$N$_4$. L'épaisseur de la couche 8 est de l'ordre de 0,12 µm. Le semiconducteur de la couche 9 peut être du silicium amorphe a-Si ou du silicium polycristallin déposé par une technique de décharge luminescente ou par LPCVD. L'épaisseur de la couche 9 est d'environ 0,1 µm. La couche 10 a une épaisseur comprise entre environ 0,2 et 0,5 µm elle peut être en oxyde de silicium SiO$_2$. La figure 7 représente le dispositif obtenu à l'issue de la huitième étape. La couche 8 ainsi que la couche 10 qui est éventuellement déposée, sont choisies en des matériaux transparents par nature. La couche semi-conductrice 9 doit être suffisamment mince pour être transparente à la lumière d'un insolateur.

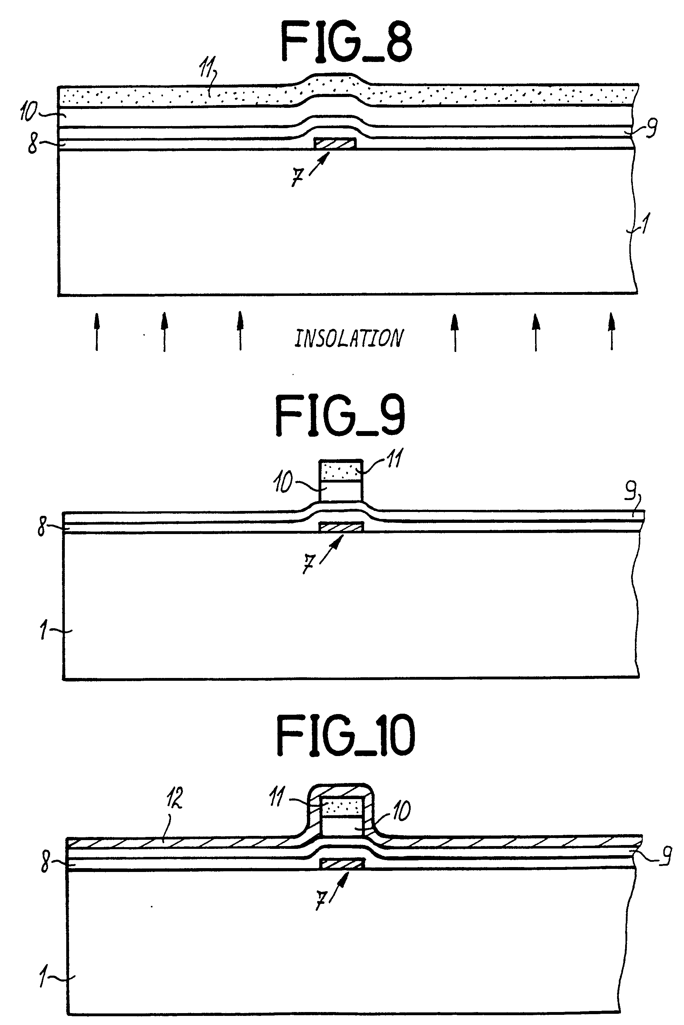

La neuvième étape comprend le dépôt d'une couche de résine photosensible 11 sur la dernière couche déposée. La résine est ensuite insolée à travers le substrat transparent 1 comme le montre la figure B. Elle est ensuite développée et il ne reste sur le dispositif que la partie de résine non insolée à cause de l'écran constitué par le ressaut métallique 7. Dans le cas où l'on a procédé au dépôt d'une couche d'isolant de passivation 10, celle-ci est éliminée par attaque chimique à l'exception de la partie recouverte par le reste de résine. La figure 9 est illustrative du dispositif obtenu à ce stade.

Il est alors préférable de disposer de bons contacts ohmiques de source et de drain. Ces contacts ohmiques peuvent être obtenus de différentes façons. On peut par exemple effectuer un nouveau dépôt constitué par une couche de silicium amorphe a-Si dopée n$^+$. On peut encore, et c'est le cas de l'exemple d'application proposé, utiliser l'implantation ionique de la couche semiconductrice 9 par des dopants tels que des ions phosphore ou arsenic. L'autoalignement est alors réalisé grâce aux éléments subsistant des couches d'isolant de passivation 10 et de résine 11. Typiquement, les doses d'ions implantés sont de l'ordre de quelques $10^{16}$/cm$^2$ pour une énergie variant de 50 à 250 keV selon l'épaisseur de la couche semiconductrice. Il est intéressant de procéder à une implantation à différents niveaux d'énergie afin d'optimiser la répartition des ions implantés en fonction des performances demandées aux transistors. Après l'implantation ionique, un recuit est nécessaire afin de réactiver les implants. L'activation des implants est réalisée par un recuit sous un flux de gaz neutre à une température de l'ordre de 200 à 300°C. L'obtention des contacts ohmiques de source et de drain constitue la dixième étape du procédé.

La onzième étape du procédé comprend le dépôt d'une couche métallique 12 destinée à former les électrodes de source et de drain. La couche métallique 12, par exemple en aluminium et d'une épaisseur d'environ 0,2 µm est déposée par évaporation. La figure 10 illustre le dispositif obtenu à ce stade du procédé. La onzième étape comprend également le lift-off de la résine

résiduelle 11, ce qui constitue une première délimitation des électrodes de source et de drain.

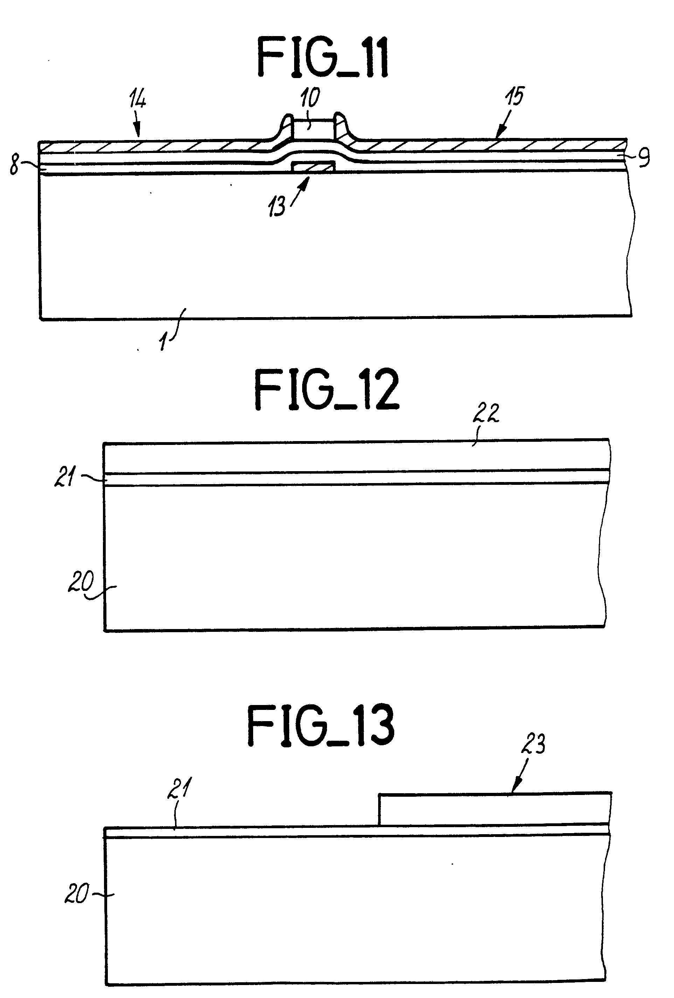

La douzième étape du procédé permet de délimiter parfaitement les électrodes de grille 13, de source 14 et de drain 15. Ceci constitue un deuxième niveau de masquage qui peut aussi servir à réaliser une mésa de l'ensemble formé par un transistor. Le dispositif final obtenu est représenté à la figure 11.

Dans ce processus technologique à grille de petite dimension, il faut prendre garde à ne pas déposer des couches actives et passivantes trop épaisses de façon à rester compatible avec la précision limite de l'insolateur qui est fonction de la longueur d'onde utilisée (de 360 à 420 nm). Si les couches 8 et 9 sont trop épaisses, il peut se produire des phénomènes de diffraction et de réfraction de la lumière d'insolation puisque ces couches présentent des flancs inclinés par rapport au substrat dus à l'épaisseur de l'électrode de grille. Ces phénomènes peuvent avoir une influence néfaste sur la précision imposée quant à la longueur du canal. Une plus grande précision peut être obtenue par une seconde variante de réalisation qui élimine les flancs susmentionnés.

La seconde variante du procédé de fabrication est illustrée par les figures 12 à 19. La figure 12 correspond à la première étape du procédé qui consiste à déposer successivement sur un substrat isolant et transparent 20, une première couche d'isolant 21 et une couche 22 d'un premier matériau différent de l'isolant 21. La couche 21, d'une épaisseur d'environ 100 nm, peut être en nitrure de silicium $Si_3N_4$. La couche 22 peut être en oxyde de silicium $SiO_2$ et avoir une épaisseur d'environ 0,5 µm. Le substrat 20 peut être en verre.

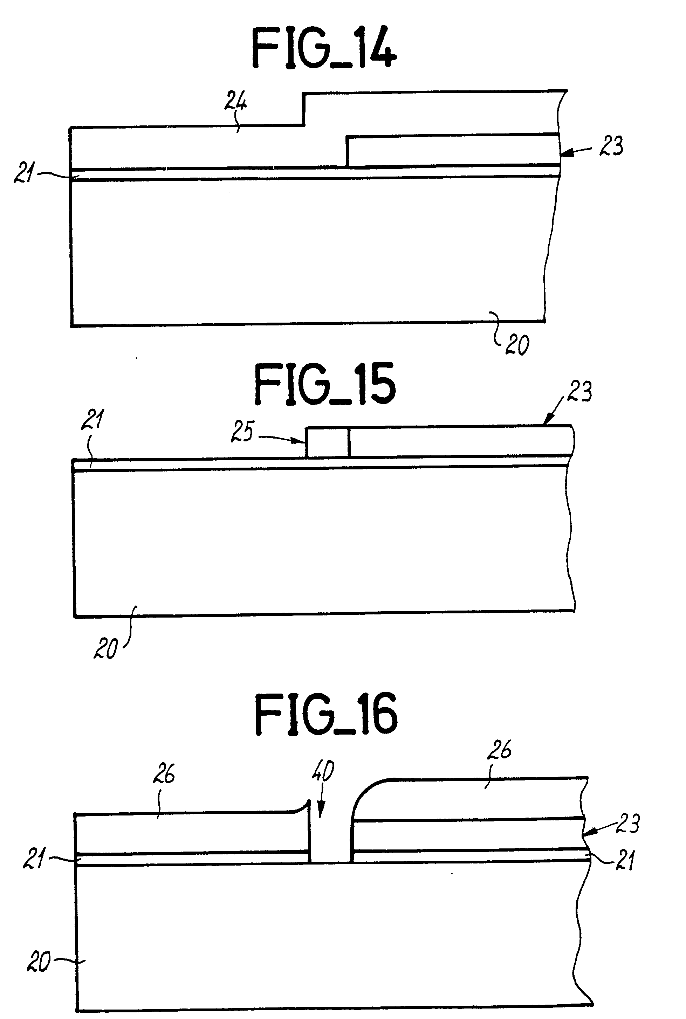

La deuxième étape du procédé illustrée par la figure 13, comporte, comme pour la première variante, la gravure de la couche 22 de façon à réaliser une mésa 23 (premier niveau de masquage). La troisième étape est constituée par le dépôt d'une couche 24 d'un second matériau comme indiqué à la figure 16. Cette couche recouvre la mésa 23 et la face découverte de la couche 21. La couche 24 peut être en silicium amorphe et être déposée par LPCVD ou par CVD assisté plasma son épaisseur dépend de la longueur de canal désiré. Typiquement, l'épaisseur de la couche 24 est de 0,5 à 1 µm. La quatrième étape du procédé est constituée par l'attaque directionnelle de la couche 24. Cette attaque est menée, comme illustré à la figure 15, jusqu'à ne laisser subsister de la couche 24 que le ressaut 25 sur le flanc de la mésa 23. Comme dans la première variante du procédé, il peut s'agir d'une attaque RIE. A ce stade du procédé, le dispositif est semblable à celui obtenu à l'issue de la quatrième étape de la première variante avec comme différence essentielle que la couche directement supportée par le substrat est isolante et non plus métallique.

La cinquième étape comprend le dépôt d'une couche 26 d'un troisième matériau différent des matériaux des couches 24 et 21. Si la couche 21 est en nitrure de silicium et la couche 24 en silicium amorphe, la couche 26 peut être en oxyde de silicium $SiO_2$. Par lift-off du ressaut 25, on obtient un trou submicronique correspondant à l'emplacement du ressaut 25 et de la partie de la couche 26 située juste au-dessus de ce ressaut. La sixième étape consiste à approfondir le trou submicronique obtenu à l'étape précédente. Ceci peut être réalisé par attaque plasma d'autant plus facilement si la couche 21 est en nitrure de silicium et la mésa 23 ainsi que la couche 26 en oxyde de silicium. L'attaque peut être menée jusqu'à atteindre le substrat 20 comme le montre la figure 16 où le trou submicronique porte la référence 40.

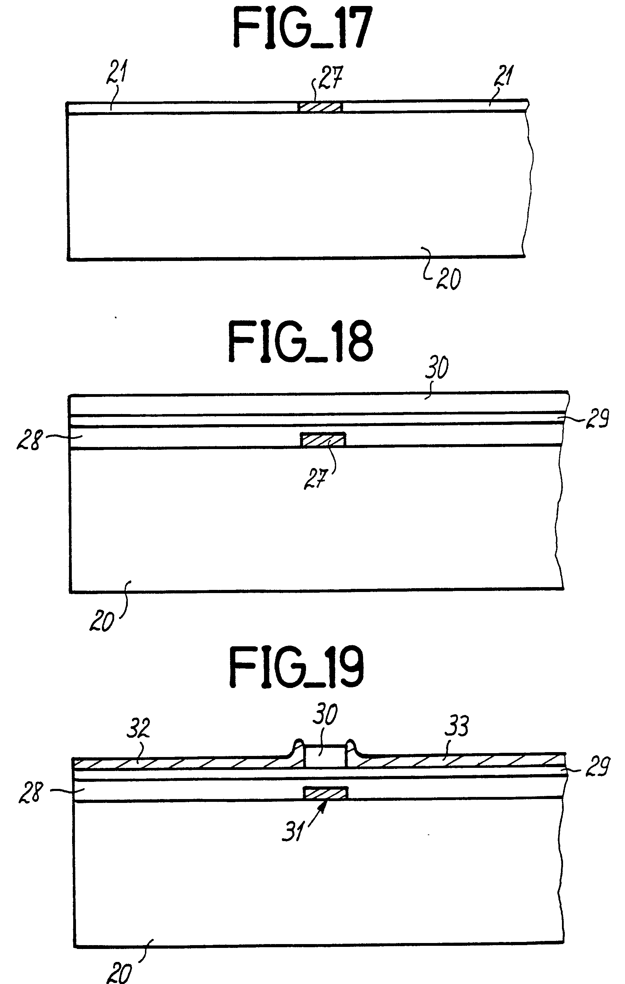

La septième étape du procédé comporte le dépôt d'une couche métallique sur le dispositif obtenu à l'issue de la sixième étape. Ce dépôt est de préférence réalisé par évaporation d'un métal tel que l'aluminium par effet Joule afin d'éviter l'accrochage du métal sur les flancs du trou. On évapore, par exemple, la quantité de métal nécessaire pour combler la partie du trou 40 correspondant à la couche 21. La septième étape comprend également le lift-off des couches 23 et 26 qui, dans l'exemple d'application choisi, sont toutes deux en oxyde de silicium $SiO_2$. Le dispositif se présente alors tel que le montre la figure 17.

La suite des opérations est identique à celles de la première variante qui leur correspondent. La huitième étape comprend les dépôts successifs d'une couche d'isolant, par exemple en $Si_3N_4$, destinée à former avec la couche d'isolant 21 une couche commune d'isolant de grille 28, d'une couche d'un matériau semiconducteur 29 et, éventuellement, d'une couche d'un isolant de passivation 30. Le dispositif obtenu se présente comme le montre la figure 18. Le semiconducteur de la couche 29 peut être du silicium amorphe ou polycristallin. L'isolant de passivation peut être en oxyde de silicium $SiO_2$. Les épaisseurs des couches 28, 29 et 30 sont du même ordre que celles des couches correspondantes de la première variante décrite.

La neuvième étape comprend le dépôt d'une couche de résine photosensible, son insolation à partir de la seconde face du substrat 20 et l'élimination de la partie insolée de la résine. Dans le cas où l'on a procédé au dépôt d'une couche d'isolant de passivation 30, celle-ci est éliminée par attaque chimique à l'exception de la partie recouverte par le reste de résine.

La dixième étape comprend la réalisation des contacts ohmiques de source et de drain de la manière décrite précédemment. La onzième étape comprend le dépôt d'une couche métallique destinée à former les électrodes de source et de drain cette couche, d'une épaiseur d'environ 0,2 µm peut être déposée par évaporation. Cette étape comprend également le lift-off de la résine résiduelle ce qui constitue une première délimitation des électrodes de source et de drain. La douzième étape du procédé permet de délimiter parfaitement les électrodes de grille 31, de source 32 et de drain 33. Cette opération nécessite un deuxième niveau de masquage qui peut également servir à réaliser une mésa de l'ensemble formé par un transistor. Le dispositif final obtenu est représenté à la figure 19.

Les deux variantes du procédé permettent la fabrication d'un transistor dont le canal possède une longueur comprise entre 0,5 et 1 µm pour une largeur d'environ 100 µm.

**Revendications**

1. Procédé de fabrication d'au moins un transistor à effet de champ, en couche mince, du type à autoalignement des électrodes, le transistor étant élaboré à partir de dépôts successifs effectués sur une première face d'un substrat isolant et transparent (1), caractérisé en ce que le procédé comprend les étapes suivantes:
   - première étape: dépôts successifs sur ladite première face du substrat (1) d'une première couche métallique (2) et d'une couche d'un premier matériau (3),
   - deuxième étape: formation d'une mésa (4) dudit premier matériau (3),
   - troisième étape: dépôt d'une couche d'un second matériau (5) différent du premier et d'épaisseur déterminée,
   - quatrième étape: attaque dudit second matériau (5) menée de façon à ne laisser qu'un ressaut (6) du second matériau situé sur le flanc de la mésa (4),
   - cinquième étape: attaque de la mésa (4) jusqu'à son élimination complète,
   - sixième étape: formation de l'électrode de gille par attaque de ladite première couche métallique (2) menée jusqu'à ne laisser qu'un ressaut métallique (7) protégé par le ressaut (6) de second matériau,
   - septième étape: attaque du ressaut (6) de second matériau jusqu'à son élimination complète,
   - huitième étape: dépôts successifs d'une couche d'isolant de grille (8) et d'une couche d'un matériau semiconducteur (9),
   - neuvième étape: dépôt d'une couche de résine photosensible (11), insolation de la résine à partir de la seconde face du substrat (1), le ressaut métallique (7) servant d'écran, et élimination de la partie insolée de la résine,
   - dixième étape: réalisation de contacts ohmiques de source et de drain,
   - onzième étape: dépôt d'une seconde couche métallique (12) et retrait de la résine et de la partie de la seconde couche métallique la recouvrant,
   - douzième étape: délimitation des électrodes de source (14) et de drain (15) et de grille (13).

7. Procédé de fabrication selon la revendication 1, caractérisé en ce que la première couche métallique (7) est une couche d'aluminium déposée par évaporation.

3. Procédé de fabrication selon la revendication 1, caractérisé en ce que la première couche métallique est une couche de chrome ou d'un alliage de nickel et de chrome déposée par évaporation.

4. Procédé de fabrication selon l'une quelconque des revendications 1 à 3, caractérisé en ce que ledit premier matériau (3) est de l'oxyde de silicium $SiO_2$.

5. Procédé de fabrication selon l'une quelconque des revendications 1 à 4, caractérisé en ce que ledit second matériau (5) est du silicium amorphe ou polycristallin déposé par LPCVD ou par CVD assisté plasma.

6. Procédé de fabrication selon l'une quelconque des revendications 1 à 5, caractérisé en ce que l'attaque dudit second matériau (5) réalisée lors de le quatrième étape est une attaque ionique réactive (RIE).

7. Procédé de fabrication selon l'une quelconque des revendications 1 à 6, caractérisé en ce que l'isolant de grille (8) est de l'oxyde de silicium $SiO_2$, de l'oxynitrure de silicium SiON ou du nitrure de silicium $Si_3N_4$.

8. Procédé de fabrication selon l'une quelconque des revendications 1 à 7, caractérisé en ce que le matériau semiconducteur (9) déposé à la huitième étape est du silicium amorphe ou du silicium polycristallin.

9. Procédé de fabrication selon l'une quelconque des revendications 1 à 8, caractérisé en ce que les contacts ohmiques de la dixième étape sont obtenus par un dépôt de semiconducteur dopé n.

10. Procédé de fabrication selon l'une quelconque des revendications 1 à 8, caractérisé en ce que les contacts ohmiques de la dixième étape sont obtenus par implantation ionique suivie d'un recuit.

11. Procédé de fabrication selon la revendication 10, caractérisé en ce que l'implantation est réalisée par des ions phosphore ou arsenic.

12. Procédé de fabrication selon l'une des revendications 10 ou 11, caractérisé en ce que l'implantation ionique est effectuée selon différents niveaux d'énergie.

13. Procédé de fabrication selon l'une quelconque des revendications 1 à 12, caractérisé en ce que ladite seconde couche métallique (12) est de l'aluminium déposé par évaporation.

14. Procédé de fabrication selon l'une quelconque des revendications 1 à 13, caractérisé en ce que, lors de la huitième étape, on dépose en outre une couche d'un isolant de passivation (10) sur la couche semiconductrice (9) et que, à la fin de la neuvième étape, on élimine la partie de l'isolant de passivation (10) non protégée par la partie non insolée de la résine.

15. Procédé de fabrication d'au moins un transistor à effet de champ, en couche mince, du type à autoalignement des électrodes, le transistor étant élaboré à partir de dépôts successifs effectués sur une première face d'un substrat isolant et transparent (20), caractérisé en ce que le procédé comprend les étapes suivantes:

- première étape: dépôts successifs sur la dite première face du substrat (20) d'une première couche d'isolant (21) et d'une couche d'un premier matériau (22),
- deuxième étape: formation d'une mésa (23) dudit premier matériau (22),
- troisième étape: dépôt d'une couche d'un second matériau (24) différent du premier et d'épaisseur déterminée,
- quatrième étape: attaque dudit second matériau (24) menée de façon à ne laisser qu'un ressaut (25) du second matériau situé sur le flanc de la mésa (23),
- cinquième étape: dépôt d'une couche d'un troisième matériau (26) et formation d'un trou (40) par retrait dudit ressaut (25),
- sixième étape: approfondissement dudit trou (40) par attaque de la première couche d'isolant (21) jusqu'à ladite première face du substrat (20),
- septième étape: dépôt d'une première couche métallique et retrait des couches de premier et second matériau (23, 26) pour former l'électrode de grille,
- huitième étape: dépôts successifs d'une seconde couche d'isolant destinée à former avec la première couche d'isolant (21) la couche d'isolant de grille (28), et d'une couche d'un matériau semiconducteur (29),
- neuvième étape: dépôt d'une couche de résine photosensible, insolation de la résine à partir de la seconde face du substrat (20), l'électrode de grille servant d'écran, et élimination de la partie insolée de la résine,
- dixième étape: réalisation de contacts ohmiques de source et de drain,
- onzième étape: dépôt d'une seconde couche métallique et retrait de la résine et de la partie de la seconde couche métallique la recouvrant,
- douzième étape: délimitation des électrodes de source (32) de drain (33) et de grille.

16. Procédé de fabrication selon le revendication 15, caractérisé en ce que la première couche d'isolant (21) est en nitrure de silicium $Si_3N_4$.

17. Procédé de fabrication selon l'une des revendications 15 ou 16, caractérisé en ce que la couche du premier matériau (22) est en oxyde de silicium $SiO_2$.

18. Procédé de fabrication selon l'une quelconque des revendications 15 à 17, caractérisé en ce que ledit second matériau (24) est en silicium amorphe.

19. Procédé de fabrication selon l'une quelconque des revendications 15 à 18, caractérisé en ce que l'attaque dudit second matériau (24) réalisée lors de la quatrième étape est une attaque ionique réactive (RIE).

20. Procédé de fabrication selon l'une quelconque des revendications 15 à 19, caractérisé en ce que ledit troisième matériau (26) est différent des matériaux de la première couche d'isolant (21) et dudit second matériau (25).

21. Procédé de fabrication selon la revendication 20, caractérisé en ce que le troisième matériau (26) est de l'oxyde de silicium $SiO_2$.

22. Procédé de fabrication selon l'une quelconque des revendications 15 à 21, caractérisé en ce que ladite première couche métallique est déposée par évaporation.

23. Procédé de fabrication selon l'une quelconque des revendications 15 à 22, caractérisé en ce que le matériau semiconducteur (29) déposé lors de le huitième étape est en silicium amorphe ou en silicium polycristallin.

24. Procédé de fabrication selon l'une quelconque des revendications 15 à 23, caractérisé en ce que les contacts ohmiques de la dixième étape sont obtenus par un dépot de semiconducteur dopé n.

25. Procédé de fabrication selon l'une quelconque des revendications 15 à 23, caractérisé en ce que les contacts ohmiques de la dixième étape sont obtenus par implantation ionique suivie d'un recuit.

26. Procédé de fabrication selon la revendication 25, caractérisé en ce que l'implantation est réalisée par des ions phosphore ou arsenic.

27. Procédé de fabrication selon l'une des revendications 25 ou 26, caractérisé en ce que l'implantation ionique est effectuée selon différents niveaux d'énergie.

28. Procédé de fabrication selon l'une quelconque des revendications 15 à 27, caractérisé en ce que ladite seconde couche métallique est de l'aluminium déposé par évaporation.

29. Procédé de fabrication selon l'une quelconque des revendications 15 à 28, caractérisé en ce que, lors de la huitième étape, on dépose en outre une couche d'isolant de passivation (30) sur la couche semiconductrice (29) et que, à la fin de la neuvième étape, on élimine la partie de l'isolant de passivation (30) non protégée par la partie non insolée de la résine.

30. Transistor à effet de champ, en couche mince, du type à autoalignement des électrodes (13, 14, 15 ou 31, 32, 33), réalisé sur un substrat isolant (1 ou 20), caractérisé en ce qu'il a une longueur de grille comprise entre 0,5 et 1 μm et une largeur de grille d'environ 100 μm et en ce qu'il est obtenu par un procédé de fabrication selon l'une quelconque des revendications 1 à 29.

**Patentansprüche**

1. Verfahren zur Herstellung wenigstens eines Dünnschicht-Fyldeffekttransistor, vom Typ mit selbstausrichtenden Elektroden, wobei der Transistor aus aufeinanderfolgenden Ablagerungen hergestellt wird, welche auf einer ersten Fläche eines isolierenden und durchsichtigen Substrats (1) vorgenommen werden, dadurch gekennzeichnet, daß es die folgenden Schritte umfaßt:

- erster Schritt; diese erste Fläche des Substrats (1) wird mit einer ersten metallischen Schicht (2) und danach mit einer Schicht eines ersten Materials (3) überzogen.

- zweiter Schritt: eine Mesastruktur (4) dieses ersten Materials (3) wird gebildet,

- dritter Schritt: eine Schicht eines von dem ersten verschiedenen Materials (5) mit bestimmter Dicke wird aufgebracht,

- vierter Schritt: das Ätzen des zweiten Materials (5) wird so ausgeführt, daß nur ein Vorsprung (6) des zweiten Materials, der auf der Flanke der Mesastruktur (4) liegt, übrigbleibt,

- fünfter Schritt: Ätzen der Mesastruktur (4) bis zu ihrer vollständigen Entfernung,

- sechster Schritt: Bildung der Gate-Elektrode durch Ätzen dieser ersten metallischen Schicht (2), bis nur ein durch den Vorsprung (6) des zweiten Materials geschützter metallischer Vorsprung (7) übrigbleibt,

- siebter Schritt: Ätzen des Vorsprungs (6) des zweiten Materials bis zu seiner vollständigen Entfernung.

- achter Schritt; eine Schicht aus einem Gate-Isolierstoff (8) und eine Schicht aus einem Halbleiter-Material (9) werden nacheinander aufgebracht,

- neunter Schritt: eine Sohicht aus einem lichtempfindlichen Kunstharz (11) wird aufgebracht, das kunstharz wird ab der zweiten Fläche des Substrats (1) bestrahlt, wobei der metallische Vorsprung (7) als Schirm dient, und der bestrahlte Teil des Kunstharzes wird beseitigt,

- zehnter Schritt: Herstellung von ohmschen Kontakten zwischen der Source und dem Drain,

- elfter Schritt: eine zweite metallische Schicht (12) wird aufgebracht, und das Kunstharz sowie der Teil der es abdeckenden zweiten metallischen Schicht werden entfernt,

- zwölfter Schritt: die Elektroden der Source (14), des Drains (16) sowie des Gates (13) werden abgegrenzt.

2. Herstellungsverfahren nach Anspruch 1, dadurch gekennzeichnet, daß die erste metallische Schicht (2) eine durch Verdampfung aufgebrachte Aluminiumschicht ist.

3. Herstellungsverfahren nach Anspruch 1, dadurch gekennzeichnet, daß die erste metallische Schicht eine durch Verdampfung aufgebrachte Schicht aus Chrom oder aus einer Nickel-Chrom-Legierung ist.

4. Herstellungsverfahren nach einem der Ansprüche 1 bis 3, dadurch gekennzeichnet, daß dieses erste Material (3) Siliziumoxid $SiO_2$ ist.

5. Herstellungsverfahren nach einem der Ansprüche 1 bis 4, dadurch gekennzeichnet, daß dieses zweite Material (5) ein amorphes bzw. polykristallines Silizium ist, das durch ein LPCVD-Verfahren oder durch ein Plasma-unterstütztes CVD-Verfahren aufgebracht wird.

6. Herstellungsverfahren nach einem der Ansprüche 1 bis 5, dadurch gekennzeichnet, daß das Ätzen dieses zweiten Materials (5), welches während des vierten Schrittes vorgenommen wird, ein reaktives Ionenätzen (RIE) ist.

7. Herstellungsverfahren nach einem der Ansprüche 1 bis 6, dadurch gekennzeichnet, daß der Gato-Isolierstoff (8) Siliziumoxid $SiO_2$, Siliziumoxynitrid $SiON$ oder Siliziumnitrid $Si_3N_4$ ist.

8. Herstellungsverfahren nach einem der Ansprüche 1 bis 7, dadurch gekennzeichnet, daß das Halbleiter-Material (9), das während des achtem Schrittes aufgebracht wird. ein amorphes bzw. polykristallines Silizium ist.

9. Herstellungsverfahren nach einem der Ansprüche 1 bis 8, dadurch gekennzeichnet, daß die ohmschen Kontakte des zehnten Schrittes durch eine Ablagerung eines n-dotierten Halbleiters erhalten werden.

10. Herstellungsverfahren nach einem der Ansprüche 1 bis 8, dadurch gekennzeichnet, daß die ohmschen Kontakte des zehnten Schrittes durch eine Ionenimplantation, worauf eine Wärmebehandlung folgt, erhalten werden.

11. Herstellungsverfahren nach Anspruch 10, dadurch gekennzeichnet, daß die Implantation mit Phosphor- oder Arsen-Ionen erfolgt.

12. Herstellungsverfahren nach dem Anspruch 10 oder 11, dadurch gekennzeichnet, daß die Ionenimplantation mit verschiedenen Energieniveaus erfolgt.

13. Herstellungsverfahren nach einem der Ansprüche 1 bis 12, dadurch gekennzeichnet, daß diese zweite metallische Schicht (12) durch Verdampfung aufgebrachtes Aluminium ist.

14. Herstellungsverfahren nach einem der Ansprüche 1 bis 13, dadurch gekennzeichnet, daß während des achten Schrittes eine Schicht aus einem Passivierungs-Isoliermaterial (10) auf der Halbleiter-Schicht (9) aufgebracht wird und daß am Ende des neunten Schrittes der Teil des Passivierungs-Isoliermaterials (10), welcher nicht durch dem unbestrahlten Teil des Runstharzes geschützt ist, entfernt wird.

15. Verfahren zur Herstellung wenigsten, eines Dünnschicht-Feldeffekttransistors vom Typ mit selbstausrichtenden Elektroden, wobei der Transistor aus aufeinanderfolgenden Ablagerungen hergestellt wird, welche auf einer ersten Fläche eines isolierenden sowie durchsichtigen Substrats (20) vorgenommen werden, dadurch gekennzeichnet, daß das Verfahren die folgenden Schritte umfaßt:

- erster Schritt; auf dieser ersten Fläche des Substrats (20) werden eine erste Isolierschicht (21) sowie eine Schicht (22) aus einem ersten Material nacheinander aufgebracht,

- zweiter Schritt: Bildung einer Mesastruktur (23) aus diesem ersten Material (22),

- dritter Schritt: eine Schicht aus einem zweiten, von dem ersten verschiedenen Material (24) mit bestimmter Dicke wird aufgebracht,

- vierter Schritt: das Ätzen dieses zweiten Materials (24) wird so ausgeführt, daß nur ein Vorsprung (25) des zweiten Materials, der auf der Flanke der Mesastruktur (23) liegt, übrigbleibt,

- fünfter Schritt: Aufbringen einer Schicht aus einem dritten Material (26) sowie Bildung eines Loches (40) durch Entfernung dieses Vorsprunges (25),

- sechter Schritt: Vertiefen dieses Lochs (40) durch Ätzen der ersten Isolierschicht (21) bis zu dieser ersten Fläche des Substrats (20),

- siebter Schritt: Aufbringen einer ersten metallischen Schicht sowie Entfernen der Schichten des ersten und des zweiten Materials (23, 26), um die Gate-Elektrode zu bilden,

- achter Schritt: eine zweite Isolierschicht, welche dazu bestimmt ist, mit der ersten Isolierschicht (21) die Gate-Isolierschicht zu bilden, sowie eine Schicht aus einem Halbleiter-Material (29) werden nacheinander aufgebracht,

- neunter Schritt: Aufbringen einer lichtempfindlichen Kunstharz-Schicht, Bestrahlung des Kunztharzes ab der zweiten Fläche des Substrats (20), wobei die Gate-Elektrode als Schirm dient, sowie Entfernung des bestrahlten Teils des Kunstharzes,

- zehnter Schritt; Herstellung von ohmschen Kontakten zwischen der Source und dem Drain,

- elfter Schritt: Aufbringen einer zweiten metallischen Schicht, Entfernen des Kunstharzes sowie des Teils der zweiten, ihn abdechenden metallischen Schicht,

- zwölfter Schritt: Abkrenzung der Elektroden der Source (32), des Drains (33) sowie des Gates.

16. Herstellungsverfahren nach Anspruch 15, dadurch gekennzeichnet, daß die erste Isolierschicht (21) Siliziumnitrid $Si_3N_4$ ist.

17. Herstellungsverfahren nach Anspruch 15 oder 16, dadurch gekennzeichnet, daß die Schicht des ersten Materials (22) Siliziumoxid $SiO_2$ ist.

18. Herstellungsverfahren nach einem der Ansprüche 15 bis 17, dadurch gekennzeichnet, daß dieses zweite Material (24) amorphes Silizium ist.

19. Herstellungsverfahren nach einem der Ansprüche 15 bis 18, dadurch gekennzeichnet, daß das Ätzen dieses zweiten Materials (24), welches während des vierten Schrittes erfolgt, ein reaktives Ionenätzen (RIE) ist.

20. Herstellungsverfahren nach einem der Ansprüche 15 bis 19, dadurch gekennzeichnet, daß dieses dritte Material (26) von den Materialen der ersten Isolierschicht (21) sowie von diesem zweiten Material (26) verschieden ist.

21. Herstellungsverfahren nach Anspruch 20, dadurch gekennzeichnet, daß das dritte Material (26) Siliziumoxid $SiO_2$ ist.

22. Herstellungsverfahren nach einem der Ansprüche 15 bis 21, dadurch gekennzeichnet, daß diese erste metallische Schicht durch Verdampfung aufgebracht wird.

23. Herstellungsverfahren nach einem der Ansprüche 15 bis 22, dadurch gekennzeichnet, daß das Halbleiter-Material (29), das währehd des achten Schrittes aufgebracht wird, ein amorphes bzw. ein polykristallines Silizium ist.

24. Herstellungsverfahren nach einem der Ansprüche 15 bis 23, dadurch gekennzeichnet, daß die ohmschen Kontakte des zehnten Schrittes durch eine Ablagerung eines n-dotierten Halbleiters erhalten werden.

25. Herstellungsverfahren nach einem der Ansprüche 16 bis 23, dadurch gekennzeichnet, daß die ohmschen Kontakte des zehnten Schrittes durch eine Ionenimplantation erhalten werden, auf die eine Wärmebehandlung folgt.

26. Herstellungsverfahren nach Anspruch 25, dadurch gekennzeichnet, daß die Implantation durch Phosphor- bzw. Arsen-Ionen erfolgt.

27. Herstellungsverfahren nach Anspruch 25 oder 26, dadurch gekennzeichnet, daß die Ionenimplantation mit verschiedenen Energieniveaus erfolgt.

28. Herstellungsverfahren nach einem der Ansprüche 15 bis 27, dadurch gekennzeichnet, daß diese zweite metallische Schicht ein durch Verdampfung aufgebrachtes Aluminium ist.

29. Herstellungsverfahren nach einem der Ansprüche 15 bis 28, dadurch gekennzeichnet, daß ferner während des achten Schrittes eine Passivierungsisolierschicht (30) auf der Halbleiter-Schicht (29) aufgebracht wird und daß am Ende des neunten Schrittes der Teil des Passivierungs-Isoliermaterial, (30), welcher nicht durch den unbestrahlten Teil des Kunstharzes geschützt ist, entfernt wird.

30. Dünnschicht-Feldeffekttransistor vom Typ mit selbstausrichtenden Elektroden (13, 14, 15 oder 31, 32, 33), der auf einem isolierenden Substrat (1 oder 20) gebildet wird, dadurch gekennzeichnet, daß er eine Gatelänge, welche zwischen 0,5 und 1 μm beträgt, sowie eine Gatebreite von ca. 100 μm aufweist, und daß er durch ein Herstellungsverfahren nach einem der Ansprüche 1 bis 29 gewonnen ist.

**Claims**

1. A process for the manufacture of at least one thin film field effect transistor, of the electrode autoalignment type, said transistor being manufactured starting with successive deposits effected on a first face of an insulating and transparent substrate (1), characterized in that the process comprises the following stages:

- first stage: successive deposits on the said first face of the substrate (1) of a first metallic layer (2) and of a layer of a first material (3),

- second stage: formation of a mesa (4) of the said first material (3),

- third stage: deposit of a second material (5) different from the first one and of a predetermined thickness,

- fourth stage: erosion of the second material (5) carried out in such a fashion as to only leave a protrusion (6) of the second material situated on the flank of the mesa (4),

- fifth stage: erosion of the mesa (4) until same is completely eliminated,

- sixth stage: formation of the gate electrode by erosion of said first metallic layer (2) and performed so as to only leave a metallic protrusion (7) protected by the protrusion of the second material (6),

- seventh stage: erosion of the protrusion of the second material (6) until same is completely eliminated,

- eighth stage: successive deposits of a gate insulating layer (8) and of a layer of a semiconductor material (9),

- ninth stage: deposit of a layer of photosensitive resin (11), exposure of the resin from the second face of the substrate (1), the metallic protrusion (7) serving as a screen, and elimination of the exposed part of the resin,

- tenth stage: production of metallic source and drain contacts,

- eleventh stage: deposit of a second metallic layer (12) and withdrawal of the resin and of the part of the second metallic layer covering it,

- twelfth stage: delimitation of the source (14) electrode, the drain (15) electrode and of the gate (13).

2. The process for the manufacture as claimed in claim 1, characterized in that the first metallic layer (2) is an aluminum layer deposited from the vapor phase.

3. The process of manufacture as claimed in claim 1, characterized in that the first metallic layer is a layer of chromium or of an alloy of nickel and chromium deposited from the vapor phase.

4. The process of manufacture as claimed in any one of the claims 1 through 3, characterized in that the said first material (3) is made of silicon oxide $SiO_2$.

5. The process of manufacture as claimed in any one of the claims 1 through 4, characterized in that the said material (5) is amorphous or polycrystalline silicon deposited by plasma assisted LPCVD or CVD.

6. The process of manufacture as claimed in any one of the preceding claims 1 through 5, characterized in that the erosion of the second material (5) performed in the fourth stage is a reactive ionic erosion (RIF).

7. The process of manufacture as claimed in any one of claims 1 through 6 characterized in that the insulator of the gate (8) is silicon oxide $SiO_2$, silicon oxynitride SiON or silicon nitride $Si_3N_4$.

8. The process of manufacture as claimed in any one of claims 1 through 7, characterized in that the semiconductor material (9) deposited in the eighth stage is amorphous or polycrystalline silicon.

9. The process of manufacture as claimed in any one of claims 1 through 8, characterized in that the ohmic contacts of the second stage are produced using a deposit of an n doped semiconductor.

10. The process of manufacture as claimed in any one of the claims 1 through 8, characterized in that the ohmic contacts of the tenth stage are obtained by ionic implantation followed by heating.

11. The process of manufacture as claimed in claim 10 or claim 11, characterized in that the implantation is performed with phosphorous or arsenic ions.

12. The process of manufacture as claimed in any one of claims 11 and 12 characterized in that the ionic implantation is effected at different energy levels.

13. The process of manufacture as claimed in claim 10 or claim 11, characterized in that the said second metallic layer (12) is aluminum deposited from the vapor phase.

14. The process of manufacture as claimed in any one of the claims 1 through 13, characterized in that in the course of the eighth stage a layer of a passivating insulator (10) is also deposited on the semiconductor layer (9) and that at the end of the ninth stage the part of the passivating insulator (10) not protected by the resin is eliminated.

15. A process for the manufacture of at least one thin film field effect transistor of the electrode autoalignment type, said transistor being manufactured starting with successive deposits effected on a first face of an insulating and transparent substrate (20), characterized in that the process comprises the following stages:

- first stage: successive deposits on the said first face of the substrate (20) of a first metallic layer (21) and of a layer of a first material (22),

- second stage: formation of a mesa (23) of the said first material (22),

- third stage: deposit of a second material (24) different from the first one and of a predetermined thickness,

- fourth stage: erosion of the second material (24) carried out in such a fashion as to only leave a protrusion (25) of the second material situated on the flank of the mesa (23),

- fifth stage: deposit of a layer of a third material (26) and the formation of a hole (40) by withdrawal of the said protrusion (25),

- sixth stage: deepening of the said hole (40) by erosion of the first insulating layer (23) as far as the first face of the substrate (20),

- seventh stage: deposit of a first metallic layer and withdrawal of the layers of the first and of the second materials (23 and 26) in order to form the electrode of the gate,

- eighth stage: successive deposits of second layer of insulator adapted to form, with the first insulator layer (21), the insulator layer of the gate (28) and of a layer of a semiconductor material (29),

- ninth stage: deposit of a layer of photosensitive resin, exposure of the resin from the second face of the substrate (20), the gate electrode serving as a screen, and elimination of the exposed part of the resin,

- tenth stage: production of ohmic source and drain contacts,

- eleventh stage: deposit of a second metallic layer (12) and withdrawal of the resin and of the part of the second metallic layer covering it,

- twelfth stage: delimitation of the source (32) electrode, the drain electrode (33) and of the gate.

16. The process of manufacture as claimed in claim 15 characterized in that the first insulating layer (21) is a layer of silicon nitride $Si_3N_4$.

17. The process of manufacture as claimed in claim 15 or claim 16 characterized in that the layer of the first material (22) is a layer of silicon oxide $SiO_2$.

18. The process of manufacture as claimed in any one of the claims 15 through 17, characterized in that the said second material (24) is amorphous silicon.

19. The process of manufacture as claimed in claim any one of the claims 15 through 18, characterized in that the erosion of the said second material (24) performed in the fourth stage is reactive ionic erosion (RIE).

20. The process of manufacture as claimed in any one of the claims 15 through 19, characterized in that the said third material (26) is different to the materials of the first insulating layer (21) and the second material (25).

21. The process of manufacture as claimed in claim 20, characterized in that the third material (26) is silicon oxide $SiO_2$.

22. The process of manufacture as claimed in any one of the claims 15 through 21, characterized in that the said first metallic layer is deposited from the vapor phase.

23. The process of manufacture as claimed in any one of the claims 15 through 22, characterized in that the semiconductor material (29) deposited in the eighth stage is amorphous silicon or polycrystalline silicon.

24. The process of manufacture as claimed in any one of the claims 15 through 23, cararacterized in that the ohmic contacts of the tenth stage are obtained by a deposit of n doped semiconductor.

25. The process of manufacture as claimed in any one of the claims 15 through 23, characterized in that the ohmic contacts of the tenth stage are obtained by ionic implantation followed by heating.

26. The process of manufacture as claimed in claim 25, characterized in that the implantation is performed using phosphorus or arsenic ions.

27. The process of manufacture as claimed in claim 25 or claim 26, characterized in that the ionic implantation is performed at different energy levels.

28. The process of manufacture as claimed in any one of the claims 15 through 27, characterized in that the said second metallic layer is aluminum deposited from the vapor phase.

29. The process of manufacture as claimed in any one of the claims 15 through 27, characterized in that in the course of the eighth stage a layer of a passivating insulator (30) is also deposited on the semiconductor layer (29) and that at the end of the ninth stage the part of the passivating insulator (30) not protected by the resin is eliminated.

30. A thin film field effect transistor of type with autoalignment of the electrodes (13, 14, 15 or 31, 32 and 33) produced on an insulating substrate (1 or 20), characterized in that it has a gate length of comprised between 0.5 and 1 μm and a gate breadth of approximately 100 μm and in that it is produced by a manufacturing process as claimed in any one of the claims 1 through 29.

# FIG_1

# FIG_2

# FIG_3

FIG_4

FIG_5

FIG_6

FIG_7

# FIG_8

11

10

8

7

9

1

INSOLATION

# FIG_9

11

10

8

7

9

1

# FIG_10

12

11

10

8

7

9

1

# FIG_11

*14*      *10*      *15*

*8*

*9*

*13*

*1*

# FIG_12

*22*

*21*

*20*

# FIG_13

*21*      *23*

*20*

# FIG_14

24

23

21

20

# FIG_15

21

25

23

20

# FIG_16

26

40

26

23

21

21

20

# FIG_17

# FIG_18

# FIG_19